# EUROPÄISCHE PATENTSCHRIFT

(11) **EP 0 728 405 B1**
(45) Veröffentlichungstag und Bekanntmachung des Hinweises auf die Patenterteilung: **23.09.1998**
(21) Anmeldenummer: 95917903.7
(22) Anmeldetag: 12.05.1995
(51) Int. Cl.: H05K 7/20

(54) **VORRICHTUNG ZUR ABLEITUNG DER THERMISCHEN VERLUSTLEISTUNG EINES ELEKTRONISCHEN ODER ELEKTROMECHANISCHEN BAUELEMENTES**
DEVICE FOR REMOVING HEAT DISSIPATED BY AN ELECTRONIC OR ELECTRO-MECHANICAL COMPONENT
DISPOSITIF PERMETTANT D'EVACUER LA CHALEUR DE DISSIPATION D'UN COMPOSANT ELECTRONIQUE OU ELECTROMECANIQUE

(30) Priorität: 09.09.1994 DE 4432057
(43) Veröffentlichungstag der Anmeldung: 28.08.1996
(73) Patentinhaber: ROBERT BOSCH GMBH, 70442 Stuttgart (DE)
(72) Erfinder: HUSSMANN, Dieter, D-71711 Steinheim (DE); JARES, Peter, D-71069 Sindelfingen (DE); JESSBERGER, Thomas, D-71277 Rutesheim (DE); WEBER, Didier, D-71665 Vaihingen (DE)
(86) Internationale Anmeldenummer: DE9500632
(87) Internationale Veröffentlichungsnummer: WO9608129

(56) Entgegenhaltungen:
- EP-A- 0 338 447
- WO-A-93/06705
- DE-U- 7 505 294

## Beschreibung

### Stand der Technik

Die Erfindung betrifft eine Vorrichtung zur Ableitung der thermischen Verlustleistung eines elektronischen oder elektromechanischen Bauelementes nach der Gattung des Hauptanspruchs.

Es sind bereits solche Vorrichtungen bekannt, bei denen einzelne Leistungsbauelemente an speziell dafür vorgesehene Kühlkörper angefügt werden. Beispielsweise sind die Leistungsbauelemente über Haltefedern an die Kühlkörper angedrückt, um einen ausreichenden Anpreßdruck zu gewährleisten. Hierbei sind jedoch spezielle Halte- und Kühlsbauteile und separate Fertigungsschritte bei der Montage notwendig, vgl. z.B. WO-A-9 306 705.

### Vorteile der Erfindung

Die erfindungsgemäße Vorrichtung zur Ableitung der thermischen Verlustleistung eines elektronischen oder elektromechanischen Bauelementes mit den kennzeichnenden Merkmalen des Anspruchs 1 ist insofern vorteilhaft, als auf einfache Weise das Gehäuse die Funktion des Kühlkörpers übernimmt und der nötige Anpreßdruck zur Ableitung der Verlustwärme zusammenhängend mit der Montage des Gehäuses hergestellt wird. Besondere Halteelemente sind hierbei nicht erforderlich. Es können alle auf der Leiterplatte vorhanden Leistungsbauelemente auf die erfindungsgemäße Art und Weise über das Gehäuse gekühlt werden. Bei der Montage des Gehäuses kann durch die Wahl der Befestigungsart und durch ein geeignetes Montageverfahren der jeweils notwendige Anpreßdruck hergestellt werden.

Auch durch eine geeignete Gestaltung der Kupferschichten gemäß Unteranspruch 4 kann eine Vergrößerung der wirksamen Oberfläche sowohl der Kupferschichten auf der Leiterplatte als auch an den Verbindungssegmenten eine verbesserte Ableitung der Verlustwärme erreicht werden. Die Herstellung der Lötverbindungen zwischen den beiden Oberflächen ist während des Löttauchbades der Leiterplatte auf einfache Weise durchführbar.

### Zeichnung

Ein Ausführungsbeispiel der erfindungsgemäßen Vorrichtung wird anhand der Zeichnung erläutert. Es zeigen:
Figur 1 einen Schnitt durch eine Befestigung eines Leistungsbauelementes auf einer Leiterplatte;
Figur 2 einen Schnitt durch ein oberes Gehäuseteil als Abdeckung der Leiterplatte und
Figuren 3 und 4 einen Schnitt durch ein schematisch, vergrößertes Detail eines Verbindungssegments zwischen dem Gehäuse und der Leiterplatte vor und nach der Montage des Gehäuses.

### Beschreibung des Ausführungsbeispiels

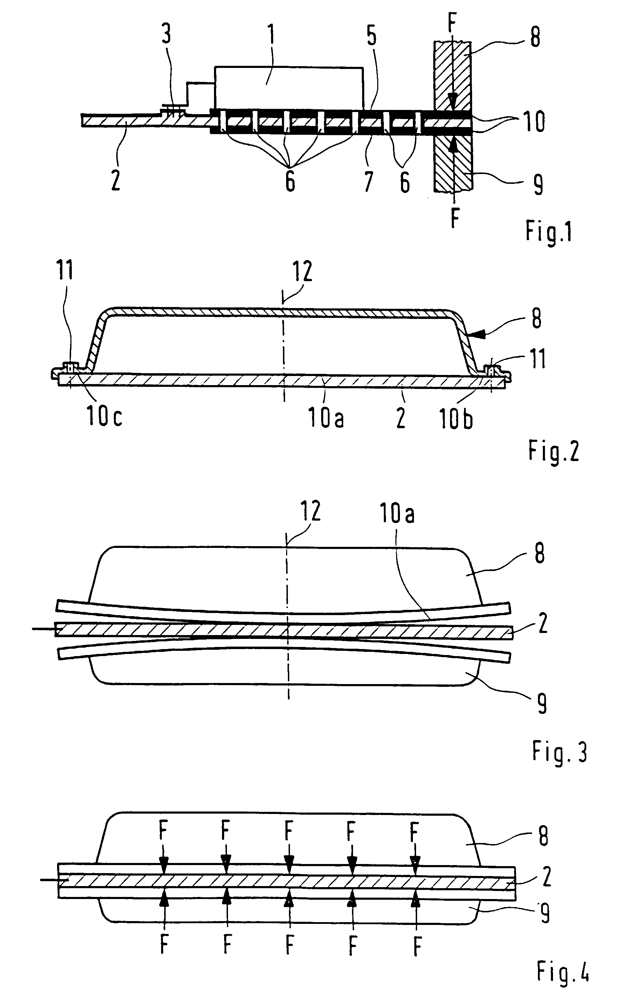

In der Figur 1 ist ein Leistungsbauelement 1, beispielsweise ein Leistungstransistor, auf einer Leiterplatte 2 befestigt. Die elektrischen Verbindungen sind über Lötanschlüsse 3 hergestellt und eine Verbindung zur Weiterleitung der Verlustwärme ist über eine integrierte Metallplatte 4, die mit einer Kupferschicht 5 fest verbunden ist, gewährleistet. Die feste Verbindung kann durch Löten oder beispielsweise durch Kleben mit einem wärmeleitenden Klebstoff hergestellt werden. Die obere Kupferschicht 5 ist über Durchgangslötösen 6 mit einer unteren Kupferschicht 7 verbunden.

Am rechten Ende der Leiterplatte 2 sind Teile eines oberen Gehäuseteils 8 und eines unteren Gehäuseteils 9 erkennbar, wobei Verbindungssegmente 10 sowohl an der oberen Seite der Leiterplatte 2 als auch an der unteren Seite der Leiterplatte 2 gebildet sind. Diese Verbindungssegmente 10 sind hier nur schematisch dargestellt, wobei die besondere Ausformung der Oberfläche und der noch notwendigen Befestigungsvorrichtungen anhand der folgenden Figuren beschrieben werden. Die Wärmeableitung erfolgt bei dem Ausführungsbeispiel nach der Figur 1 vom Leistungsbauelement 1 über die Kupferschichten 5 und 7 auf die Gehäuseteile 8 und 9. Um eine gute Wärmeableitung auf das Gehäuse zu gewährleisten, ist ein dauerhafter Anpreßdruck F von den Gehäuseteilen 8 und 9 auf die Kupferschichten 5 und 7 der Leiterplatte 2 erforderlich.

In der Figur 2 ist ein Schnitt durch das obere Gehäuseteil 8 gezeigt, das nach der Fertigstellung der Leiterplatte 2 auf dieser befestigt wird. Es sind bei dieser Darstellung zwei Befestigungslöcher 11 an den Seiten erkennbar, die beispielsweise zur Aufnahme einer Schraubverbindung dienen. In der gleichen Weise ist ein unteres Gehäuseteil (hier nicht dargestellt) anbringbar, wobei dieses durch ein geeignetes Ineinandergreifen beispielsweise durch das obere Gehäuseteil 8 mitgehalten werden kann. An den, der Leiterplatte 2 zugewandten Seiten der Gehäuseteile 8 und 9, sind die Verbindungssegmente 10a, 10b und 10c gebildet, die eine ballige Oberflächenform aufweisen. So weist beispielsweise das Verbindungssegment 10a auf der Höhe der Mittelachse 12 des Gehäuseteils 8 im unmontierten Zustand eine Erhebung von ca. 0,2 bis 0,4 mm gegenüber den Eckbereichen auf. Die Verbindungssegmente 10b und 10c verlaufen hier rechtwinklig zum Verbindungssegment 10a und sind in vergleichbarer Form ballig ausgebildet.

Da die ballige Ausbildung der Verbindungssegmente 10a, 10b und 10c bei der maßstabsgerechten Darstellung nach Figur 2 nicht erkennbar sind ist dieses anhand der Figuren 3 und 4 in vergrößerter, nicht maßstabsgerechter Form gezeigt. In der Figur 3 sind die Gehäuseteile 8 und 9 mit den Verbindungssegmenten 10a vor der Montage mit der Leiterplatte 2 dargestellt. Die ballige Ausbildung des Verbindungssegmentes 10a auf der Höhe der Mittelachse 12 ist hier deutlich erkennbar. Nach der Montage (Figur 4) schmiegt sich das Verbindungssegment 10a dicht an die Oberfläche der Leiterplatte 2 an, wobei der über die hier nicht dargestellte Befestigungsvorrichtung dauerhaft bewirkte Anpreßdruck, Kräfte F entstehen läßt, die einen hervorragenden Kontakt zwischen der Leiterplatte 2 und den Gehäuseteilen 8 und 9 zur optimalen Wärmeableitung gewährleisten.

## Patentansprüche

1. Vorrichtung zur Ableitung der thermischen Verlustleistung eines elektronischen oder elektromechanischen Bauelementes (1), bei der
- unter Aufbringung eines Kontaktdrucks eine wärmeleitende Verbindung zu einem Kühlkörper herstellbar ist,
**wobei**
- die Bauelemente (1) eine wärmeleitende Verbindung mit einer metallisch beschichteten Oberfläche einer Leiterplatte (2) haben, wobei die beschichteten Oberflächenteile (5,7) bis in ein Verbindungssegment (10,10a,10b,10c) eines die Leiterplatte (2) ganz oder teilweise umgebenden Gehäuse (8,9) hineinragen und wobei
- mindestens ein Verbindungssegment (10,10a,10b,10c) des Gehäuses (8,9) der Leiterplatte (2) gegenüberliegt und derart ballig an seiner Oberfläche ausgeführt ist, daß bei der Befestigung des Gehäuses (8,9) an der Leiterplatte (2) durch die Verformung der balligen Oberfläche ein dauerhafter Anpreßdruck zwischen Gehäuse (8,9) und Leiterplatte (2) ausgeübt wird.

2. Vorrichtung nach Anspruch 1,
**dadurch gekennzeichnet, daß**
- das Gehäuse (8,9) ein metallisches Teil ist und die ballige Oberfläche sich jeweils über das Verbindungssegment (10;10a, 10b,10c) erstreckt.

3. Vorrichtung nach Anspruch 1 oder 2,
**dadurch gekennzeichnet, daß**
- die höchste Erhebung des Verbindungssegments (10;10a, 10b,10c) eine Abweichung im Bereich von 0,2 mm bis 0,6 mm von der Ebene aufweist.

4. Vorrichtung nach einem der Ansprüche 1 bis 3,
**dadurch gekennzeichnet, daß**
- das Gehäuse (8,9) die Leiterplatte (2) auf mindestens einer Seite ganz umschließt und an vier Ecken mit Schraubverbindungen an der Leiterplatte (2) befestigt ist.

5. Vorrichtung nach einem der Ansprüche 1 bis 3,
**dadurch gekennzeichnet, daß**
- die wärmeableitenden Schichten (5,7) auf beiden Seiten der Leiterplatte (2) angeordnet und über Durchgangslötösen (6) in der Leiterplatte (2) miteinander verbunden sind.

## Claims

1. Device for dissipating the thermal power loss of an electronic or electromechanical component (1), in which
- a thermally conducting connection to a heat sink can be produced by applying a contact pressure,
it being the case that
- the components (1) have a thermally conducting connection to a metal-coated surface of a printed circuit board (2), the coated surface parts (5, 7) projecting as far as into a connecting segment (10;10a,10b,10c) of a housing (8, 9) completely or partially surrounding the printed circuit board (2), and it being the case that
- at least one connecting segment (10;10a,10b,10c) of the housing (8, 9) is situated opposite the printed circuit board (2) and is designed with a convex surface in such a way that when the housing (8, 9) is fastened to the printed circuit board (2) the deformation of the convex surface exerts a permanent contact pressure between the housing (8, 9) and printed circuit board (2).

2. Device according to Claim 1, characterized in that
- the housing (8, 9) is a metallic part and the convex surface extends in each case over the connecting segment (10;10a,10b,10c).

3. Device according to Claim 1 or 2, characterized in that
- the highest elevation of the connecting segment (10;10a,10b,10c) has a deviation in the range from 0.2 mm to 0.6 mm from the plane.

4. Device according to one of Claims 1 to 3, characterized in that
- the housing (8, 9) surrounds the printed circuit board (2) completely on at least one side and is fastened to the printed circuit board (2) at four corners by means of screwed joints.

5. Device according to one of Claims 1 to 3, characterized in that
- the thermally dissipating layers (5, 7) are arranged on both sides of the printed circuit board (2) and connected to one another via feed-through solder tags (6) in the printed circuit board (2).

## Revendications

1. Dispositif pour évacuer la chaleur dégagée par un composant électronique ou électromécanique (1), selon lequel :
- en exerçant une pression de contact, on réalise une liaison conductrice de chaleur d'un organe de refroidissement,
- les composants (1) ont une liaison conductrice de chaleur avec une surface à revêtement métallique d'une plaque conductrice (2), les parties de surface (5, 7), munies d'un revêtement, jusque dans un segment de liaison (10, 10a, 10b, 10c) d'un boîtier (8, 9) entourant totalement ou partiellement la plaque de circuit imprimé (2), y pénètrent totalement et,
- au moins un segment de liaison (10, 10a, 10b, 10c) du boîtier (8, 9) est en regard de la plaque du circuit imprimé (2) et présente une surface supérieure bombée pour qu'à la fixation du boîtier (8, 9) sur la plaque de circuit imprimé (2), par déformation de la surface bombée, on crée une pression d'application permanente entre le boîtier (8, 9) et la plaque de circuit imprimé (2).

2. Dispositif selon la revendication 1,
caractérisé en ce que
le boîtier (8, 9) est une pièce métallique et la surface bombée s'étend chaque fois sur le segment de liaison (10, 10a, 10b, 10c).

3. Dispositif selon la revendication 1 ou 2,
caractérisé en ce que
le bossage le plus haut du segment de liaison (10, 10a, 10b, 10c) présente une déviation par rapport à une surface plane de l'ordre de 0,2 mm à 0,6 mm.

4. Dispositif selon l'une des revendications 1 à 3,
caractérisé en ce que
le boîtier (8, 9) entoure la plaque de circuit imprimé (2) totalement sur au moins un côté et est fixé aux quatre côtés à la plaque de circuit imprimé (2) par des liaisons vissées.

5. Dispositif selon l'une des revendications 1 à 3,
caractérisé en ce que
les couches conductrices de chaleur (5, 7) sont prévues sur les deux faces de la plaque de circuit imprimé (2) et sont reliées par des oeillets brasés traversants (6) dans la plaque de circuit imprimé (2).
